# EUROPEAN PATENT APPLICATION

(11) **EP 4 186 993 A1**
(43) Date of publication of application: **31.05.2023**
(21) Application number: 20946075.7
(22) Date of filing: 07.12.2020
(51) Int. Cl.: C23C 28/00, C23C 14/16, C23C 14/35, C25D 11/26, F02F 3/12

(54) **PISTON MANUFACTURING METHOD AND PISTON**

(30) Priority: 23.07.2020 CN 202010717286
(71) Applicant: Weichai Power Co., Ltd., Weifang, Shandong 261061 (CN)
(72) Inventor: MA, Fei, Weifang, Shandong 261061 (CN); HAN, Jinfeng, Weifang, Shandong 261061 (CN); QI, Shaobao, Weifang, Shandong 261061 (CN); GUO, Lingyan, Weifang, Shandong 261061 (CN)
(74) Representative: Zacco Sweden AB
(86) International application number: PCT/CN2020/134197
(87) International publication number: WO 2022/016775

(57) **Abstract**

A piston manufacturing method and a piston are provided. The piston manufacturing method includes: coating a top surface of a piston base (1) using a magnetron injection method, so as to form a metal layer (2), where the metal layer (2) is a composite metal layer (2) made of aluminum oxide and zirconium oxide; and carrying out an electrochemical reaction on the metal layer (2) using a micro-arc oxidation method, so as to form a ceramic layer (3), where the ceramic layer (3) has a porous structure.

## Description

### FIELD

The present application relates to the field of machining technology, for example, to a piston manufacturing method and a piston.

### BACKGROUND

The conventional piston production and manufacture are implemented by two techniques as follows.

A first technique is to coat the top of the steel piston with a thermal barrier ceramic layer such as yttrium stabilized zirconia YSZ, magnesia partially stabilized zirconia Mg-PSZ, etc. The main material of the ceramic layer is zirconia, and the feature of low thermal conductivity of zirconia is used to reduce heat transfer and heat loss. Due to the high density and large heat capacity of zirconia, usually above 2000kJ/(m³•K), it will cause the zirconia coating to store a large amount of heat during heat insulation, thereby increasing the temperature of the combustion chamber and reducing the number of oxygen atoms entering the combustion chamber, which is not conducive to the complete combustion of fuel.

The second is to prepare a steel piston with a metal-ceramic composite coating. First, a dense metal layer such as aluminum, magnesium, and titanium is prepared on the top surface of the steel piston by arc spraying technology, and then the steel piston covered with the metal layer is secondary machined and finally an electrochemical method of hard anodizing is used to prepare a ceramic thermal barrier coating. However, the arc spraying technology has the following disadvantages. (1) The metal layer prepared by the arc spraying has a relatively large pores are distributed throughout the metal layer, which will cause the metal layer to fail to be tightly bonded to the steel piston substrate, and issues such as peeling off of coating may occur. (2) High temperature may be caused on the surface of the steel piston in arc spraying, which may result in a decrease in the high temperature strength of the steel piston substrate. In addition, although a metal-ceramic composite coating has been prepared on the surface of the steel piston, the coating does not have excellent low thermal conductivity and low heat capacity.

### SUMMARY

A piston manufacturing method and a piston are provided according to the present application, which have low heat capacity and low thermal conductivity, which reduces the heat absorption and heat transfer capabilities of the top of the piston, thereby facilitating the improvement of the thermal efficiency of the engine.

A piston manufacturing method is provided according to an embodiment, which includes:
coating a top surface of a piston base by using a magnetron injection method, to form a metal layer, where the metal layer is a composite metal layer made of aluminum oxide and zirconium oxide; and
carrying out an electrochemical reaction on the metal layer by using a micro-arc oxidation method, to form a ceramic layer, where the ceramic layer has a porous structure.

A piston is further provided according to an embodiment of the present application, which is manufactured by using the above piston manufacturing method, the piston includes:
a piston base;
a metal layer arranged on a top surface of the piston base; and
a ceramic layer arranged on a top surface of the metal layer.

### BRIEF DESCRIPTION OF THE DRAWING

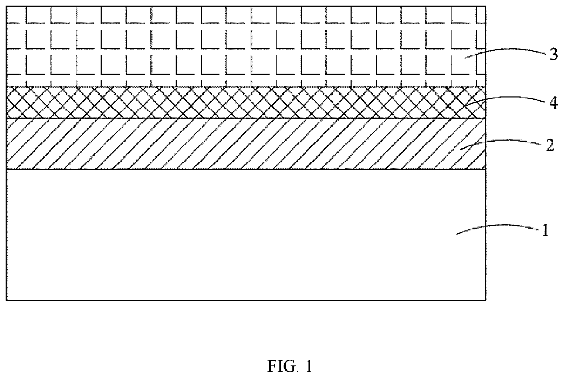

FIG. 1 is a schematic structural diagram of the piston according to the present application.

Reference numerals in the drawing:
1 piston base
2 metal layer
3 ceramic layer
4 transition layer

### DETAILED DESCRIPTION

In the description of the present application, unless otherwise expressly specified and limited, the terms "join", "connected", "fixing" are to be construed in a broad sense, for example, as permanently connected, detachably connected, or integrally connected; mechanically connected or electrically connected; directly connected to each other or indirectly connected to each other via an intermediary; or internally connection of two components or interacting relationship of two elements. For those of ordinary skill in the art, specific meanings of the preceding terms in the present application may be construed based on specific situations.

In this application, unless otherwise expressly specified and limited, a first feature being "on" or "under" a second feature may include direct contact between the first feature and the second feature, and may also include the first feature and the second feature not in direct contact but contact through another feature between them. Moreover, the first feature "on", "above" and "over" the second feature include that the first feature is directly above and obliquely above the second feature, or simply means that the horizontal level of the first feature is higher than the horizontal level of the second feature. The first feature "under", "below" and "beneath" the second feature include that the first feature is directly below and obliquely below the second feature, or simply means that the horizontal level of the first feature is smaller than the horizontal level of the second feature.

The conventional piston is a part of the combustion chamber, and the top of the piston absorbs a large amount of heat when fuel is burned, and the heat is required to be transferred to a cylinder liner through the piston, and then the heat is taken away by a cooling medium of an engine, thereby cooling the piston. The lost heat will reduce the thermal efficiency of the engine. In order to address this issue, as shown in FIG. 1, a piston is provided according to this embodiment, and the piston includes a piston base 1, a metal layer 2 and a ceramic layer 3, and the piston base 1 is made of a steel material, a metal layer 2 is arranged on a top surface of the piston base 1, and a ceramic layer 3 is arranged on a top surface of the metal layer 2.

In the piston according to this embodiment, the metal layer 2 and the ceramic layer 3 are provided on the top surface of the piston base 1 to add a composite thermal barrier ceramic coating with low heat capacity and low thermal conductivity on the top of the piston base 1 to reduce the heat absorption and heat transfer capabilities of the top of the piston base 1, thereby facilitating the improvement of the thermal efficiency of the engine. The ceramic layer 3 is arranged on the top surface of the metal layer 2, and multiple holes are arranged in the ceramic layer 3, and the holes in the ceramic layer 3 can realize heat absorption and release, thereby realizing heat insulation.

In the process of forming the ceramic layer 3 on the basis of the metal layer 2, a dense transition layer 4 is formed between the dense metal layer 2 and the ceramic layer 3.

A piston manufacturing method is further provided according to this embodiment, which is used to manufacture the above-described piston. The piston manufacturing method includes: coating a top surface of a piston base 1 by using a magnetron injection method, to form a metal layer 2, wherein the metal layer 2 is a composite metal layer 2 made of aluminum oxide and zirconium oxide; and carrying out an electrochemical reaction on the metal layer 2 by using a micro-arc oxidation method, to form a ceramic layer 3, specifically, the ceramic layer 3 has a porous structure.

In the conventional technology, the material of the thermal barrier ceramic layer 3 coated on the top of the piston is zirconia, and zirconia has a relatively large heat capacity. In the piston manufacturing method according to this embodiment, a film is coated on the top surface of the piston base 1 to form the metal layer 2, and the metal layer 2 is a composite metal layer 2 of alumina and zirconia. Compared with the conventional technology that uses zirconia all, the composite metal layer 2 of alumina and zirconia adds alumina on the basis of zirconia, effectively reducing the heat capacity of the metal layer 2, thereby avoiding the situation where a large amount of heat is stored during heat insulation, causing the temperature of the combustion chamber to rise, which facilitates the full combustion of fuel. Moreover, an electrochemical reaction is performed on the metal layer 2 to form a ceramic layer 3, the ceramic layer 3 has a porous structure, making the ceramic layer 3 a loose structure, which has a low heat capacity and reduces the heat capacity of the piston base 1. In addition, the top of the metal layer 2 is electrochemically treated to form a ceramic layer 3 with pores. The ceramic layer 3 is a microscopic hole coating. The thermal conductivity of the air in the microscopic hole coating is extremely small, and the thermal conductivity of the air is poor. The heat transfer from the high temperature combusting gas to the piston base 1 effectively reduces the thermal conductivity of the piston base 1.

Using magnetron spraying and micro-arc oxidation a composite thermal barrier coating of the metal layer 2 and the ceramic layer 3 is prepared on the top of the piston base 1, which can reduce the heat absorption capacity of the piston base 1, thereby reducing the heat transfer through the piston base 1 to the cylinder liner, and improving thermal efficiency of the engine.

In order to ensure the coating effect of the metal layer 2, before the magnetron spraying, the piston base 1 is pre-treated to make the top surface of the piston base 1 smooth and to increase the adhesion of the coating.

Exemplarily, the pre-treatment includes the following steps: grinding the top surface of the piston base 1 with sandpaper to polish the top surface to be a mirror surface; placing the piston base 1 in an ultrasonic cleaning machine, and ultrasonically cleaning the piston base 1 with a cleaning agent; and ultrasonically cleaning the piston base 1 with a deionized water, and blowing the piston base 1 dry after cleaning.

Optionally, sandpaper of different fineness types is used to polish the top surface of the piston base 1 sequentially. After the piston base 1 is placed in an ultrasonic cleaner, the cleaning agent is acetone or metal cleaning agent solution, and the piston base 1 is ultrasonically cleaned for about 30 minutes, and after the cleaning is completed, deionized water is used to ultrasonically clean for about 10 minutes, and the piston base 1 is blown dry with hot air.

In order to eliminate the adverse effect of the high temperature generated by the metal layer 2 in the coating process on the densities of the piston base 1 and the metal layer 2, the top surface of the piston base 1 is coated by magnetron spraying. The magnetron spraying technique is a technology that uses energetic particles to bombard the target surface in a vacuum, so that the bombarded particles are deposited on the substrate. The magnetron spraying method requires a low temperature and will not adversely affect the high temperature strength of the piston base 1. Moreover, the atomic deposition feature of the magnetron spraying method enables the metal layer 2 to have a higher dense.

Optionally, the magnetron spraying technique includes the following steps: filling a vacuum chamber with an inert gas, and setting an aluminum target and a zirconium target respectively in the vacuum chamber; using a clamping assembly to clamp the piston base 1 and controlling the top surface of the piston base 1 to be away from the aluminum target and the zirconium target, and using a glow discharge reaction of the inert gas to generate incident ions to bombard the surface of the aluminum target and the surface of the zirconium target; and using a clamping assembly to clamp the piston base 1 and controlling the top surface of the piston base 1 to face the aluminum target and the zirconium target, to allow aluminum atoms and zirconium atoms generated by sputtering of the aluminum target and the zirconium target to be sputtered and deposited on the top surface of the piston base 1 to form the metal layer 2 of a thin film structure.

Wherein, the clamping assembly includes a clamp and a rotating shaft that can rotate relative to the vacuum chamber, the pretreated piston base 1 is clamped on the clamp, and the piston base 1 and the clamp are integrally assembled on the rotating shaft, and then the top surface of the piston base 1 faces away from the aluminum target and the zirconium target, and the aluminum target and the zirconium target are distributed up and down and set at a preset angle.

A mechanical pump is used to extract the air in the vacuum chamber. After the air pressure of the air remained after the extraction of the mechanical pump reaches a preset limit, the molecular pump is turned on, and the molecular pump will continue to pump air on this basis, to allow the air pressure in the vacuum chamber, before an inert gas is introduced, to be less than or equal to 5×10⁻⁴Pa, the vacuum chamber provides a vacuum environment for the magnetron injection, the inert gas is introduced into the vacuum chamber, and the inert gas can be argon. The pressure of the vacuum chamber is 0.1Pa-0.9Pa after the inert gas is introduced. Optionally, the pressure of the vacuum chamber is 0.5 Pa after the inert gas is introduced.

The aluminum target and the zirconium target made of coating materials are used as the cathode, and the piston base 1 is used as the anode. The currents of the aluminum target and the zirconium target are each raised to 4A, and glow discharge is caused under the action of radio frequency voltage, and the incident ions generated by glow discharge are argon ions. The argon ions bombard the surface of the aluminum target and the surface of the zirconium target for about 20 minutes, which is used for surface cleaning of the aluminum target and the zirconium target. After the cleaning is completed, the bias voltage of the piston base 1 is set to 80V, and the rotating shaft is controlled to place the top surface of the piston base 1 to face directly the aluminum target and the zirconium target, and sputtering coating is then started until the metal thickness reaches 100µm.

The sputtered aluminum atoms and zirconium atoms are splashed out after exchanging kinetic energy, so that the sputtered aluminum atoms and zirconium atoms have high energy, which facilitates the improvement of the diffusion capability of aluminum atoms and zirconium atoms during deposition, and the improvement of the denseness of the deposited structure, so that the prepared metal layer 2 thin film has a strong adhesion to the piston base 1. Compared with the technique of using arc spraying in the conventional technology, the technique of coating by magnetron spraying has high coating quality, the metal layer 2 and the piston base 1 can be tightly combined, avoiding the peeling off of the metal layer 2, and the thermal shock performance is good. In addition, magnetron sputtering can accurately control the thickness and uniformity of the metal layer 2, so that the metal layer 2 can be directly subjected to micro-arc oxidation treatment after magnetron sputtering, without secondary processing of the metal layer 2, thereby saving production process and reducing production costs.

In order to make the top coating of the piston base 1 have a low thermal conductivity, optionally, an appropriate amount of zirconia is uniformly doped in the ceramic layer 3. The traditional method of adding zirconia to the ceramic coating is realized by adding potassium fluozirconate to the electrolyte during micro-arc oxidation. After potassium fluozirconate dissolves at high temperature, its concentration increases, which may significantly increase the conductivity rate of the electrolyte, resulting in severe spark ablation during the reaction process, making the addition of zirconium element in the ceramic layer 3 prepared by this method extremely limited. Moreover, when the zirconium element is added with the electrolyte, the zirconium element cannot be uniformly distributed in the coating.

In order to address the above issues, when to perform magnetron sputtering, by controlling the content ratio of aluminum and zirconium elements, the metal layer 2 forms a ceramic layer 3 with zirconia in the electrochemical reaction, which addresses the issue of low coating denseness caused by the spraying method, and also addresses the issue of small addition of zirconia in the ceramic layer 3 after micro-arc oxidation. In addition, after magnetron sputtering, the prepared metal layer 2 is a composite metal layer 2 of alumina and zirconia. The zirconium elements in the composite metal layer 2 are evenly distributed on the top surface of the piston base 1, and the zirconia formed after the micro-arc oxidation treatment will be evenly distributed in the whole ceramic layer 3, avoiding the issue that the zirconium elements cannot be evenly distributed when they are added in the electrolyte.

Optionally, controlling the content ratio of the aluminum elements and the zirconium elements is achieved by adjusting the sputtering angles of the aluminum target and the zirconium target respectively and controlling the aluminum target and the zirconium target to sputter simultaneously. Magnetron sputtering can accurately control the composition and content of the metal layer 2 by simultaneously sputtering of the aluminum target and the zirconium target, and adjusting the sputtering angle, with a stronger adjustability, so as to realize the control of the zirconia content in the ceramic layer 3.The technique of prefabricating the composite metal layer 2 by magnetron sputtering is used to add a small amount of zirconium element to the ceramic layer 3, thereby increasing the content of the zirconium element in the ceramic layer 3, and addressing the issue of uneven distribution of added elements in the ceramic layer 3 when they are added in the electrolyte, to allow the overall property of the ceramic layer 3 to be more stable.

Exemplarily, adopting the micro-arc oxidation method includes the following steps: using a clamp assembly to clamp the piston base 1; electrically connecting a positive pole of a pulse power supply to the piston base 1, and electrically connecting a negative pole of the pulse power supply to the clamp assembly; and placing the metal layer 2 on the top surface of the piston base 1 in the electrolyte, to allow the metal layer 2 to react with the electrolyte and micro-arc discharge on the surface of the metal layer 2 to form a ceramic layer 3 on the surface of the metal layer 2. Optionally, after the metal layer 2 is prepared, the piston base 1 is taken out, and the piston base 1 is assembled on a special clamp assembly, then the piston base 1 is connected to the positive pole of the pulse power supply, and the clamp assembly is connected to the negative pole of the power supply.

The electrolyte is a silicate electrolyte, the concentration of the electrolyte is 10g/L-30g/L, the temperature of the electrolyte is less than or equal to 35°C, the current density of the pulse power supply is 0.2A/dm²-0.4A/dm², the frequency of the pulse power supply is 50Hz-500Hz, the positive current duty ratio is 40%-50%, and the positive and negative current ratio of the pulse power supply is 0.7-1.3. Optionally, 40L of silicate electrolyte is placed in a reaction circulation tank, the concentration of sodium silicate is 15g/L, which includes complexing agent, stabilizer and so on. A water cooling circulation device is started to ensure that the electrolyte temperature is less than or equal to 35°C in the process of micro-arc oxidation, and the electrical parameters of the micro-arc oxidation are set, for example: the current density of the pulse power supply is 0.3A/dm², the positive and negative current ratio of the pulse power supply is 1.2, the frequency of the pulse power supply is 400Hz, the positive duty cycle is 40%, the negative duty cycle is 40%, etc.

After the electrical parameter setting is completed, the pulse power supply is started to perform micro-arc oxidation treatment for 90 minutes. After the micro-arc oxidation treatment finishes, the pulse power supply is turned off, the water cooling circulation device is turned off after the piston base 1 is cooled, and the piston base 1 is taken from the clamping assembly, and the piston base 1 is dried with hot air.

A voltage is applied to the piston base 1 by a pulse power supply, to allow the metal layer 2 on the surface of the piston base 1 to interact with the electrolyte solution, and a micro-arc discharge is formed on the surface of the metal layer 2, and under the action of high temperature, electric field and other factors, the ceramic layer 3 is formed on the surface of the metal layer 2 to achieve the purpose of surface strengthening. Through arc discharge, the molten ceramic phase erupts from the inside of the metal layer 2 and cools rapidly after contacting the electrolyte. In this case, the discharge channel and the extremely fast solidification structure will cause the existence of pores.

The micro-arc oxidation method is adopted to obtain the ceramic layer 3 that not only maintains excellent resistance to alternating cold and heat, but also has low heat capacity, so that the porosity of the ceramic layer 3 is 15%-25%.The thermophysical properties of the ceramic layer 3 can be technologically adjusted by changing the electrical parameters and electrolyte parameters within a predetermined range according to requirements.

After the coating preparation finishes, the thermal conductivity of the coating is tested using a laser thermal conductivity meter, and the volumetric heat capacity of the coating is tested using a differential scanning calorimeter (DSC).After adding the coating on the top of the steel piston, the thermal conductivity of the top of the piston substrate 1 prepared under the above parameters is lower than 0.5W/(m•K), and the thermal conductivity is 0.42W/(m•K), while the traditional thermal conductivity of the zirconia ceramic thermal barrier coating is about 2.0W/(m•K), so the coating on the top of the piston can effectively reduce heat loss and improve the energy utilization rate of the diesel engine. While providing a better heat insulation effect, the ceramic coating prepared by this process also has a volumetric heat capacity of less than 1000kJ/(m³•K), and the heat capacity of the top of the piston base 1 prepared under the above parameters is 91 1KJ/(m³•K), so that the temperature of the combustion chamber will not be too high, ensuring sufficient quantity of oxygen atoms in the combustion process, and improving the combustion efficiency.

In the description herein, it should be understood that the terms "up", "down", "right", and other orientations or positional relationships are based on the orientations or positional relationships shown in the drawings, and are only for the convenience of description and simplification of operations. It is not intended to indicate or imply that the device or element referred to must have a particular orientation, be constructed, or operate in a particular orientation, and thus should not be construed as limiting the present application. In addition, the terms "first" and "second" are only used for distinction in description and have no special meaning.

In the description of this specification, descriptions referring to the terms "an embodiment", "example" and the like mean that specific features, structures, materials or characteristics described in conjunction with the embodiment or example are included in at least one embodiment or example of the present application. In this specification, schematic representations of the above terms do not necessarily refer to the same embodiment or example.

## Claims

1. A piston manufacturing method, comprising:
coating a top surface of a piston base (1) by using a magnetron injection method, to form a metal layer (2), wherein the metal layer (2) is a composite metal layer (2) made of aluminum oxide and zirconium oxide; and
carrying out an electrochemical reaction on the metal layer (2) by using a micro-arc oxidation method, to form a ceramic layer (3), wherein the ceramic layer (3) has a porous structure.

2. The piston manufacturing method according to claim 1, wherein the magnetron injection method comprises:
filling a vacuum chamber with an inert gas, and setting an aluminum target and a zirconium target respectively in the vacuum chamber;
using a clamping assembly to clamp the piston base (1) and controlling the top surface of the piston base (1) to be away from the aluminum target and the zirconium target, and using a glow discharge reaction of the inert gas to generate incident ions to bombard a surface of the aluminum target and a surface of the zirconium target; and
using a clamping assembly to clamp the piston base (1) and controlling the top surface of the piston base (1) to face the aluminum target and the zirconium target, to allow aluminum atoms and zirconium atoms generated by sputtering of the aluminum target and the zirconium target to be sputtered and deposited on the top surface of the piston base (1) to form the metal layer (2) of a thin film structure.

3. The piston manufacturing method according to claim 2, wherein, by controlling a content ratio of aluminum element and zirconium element, the metal layer (2) is formed with the ceramic layer (3) with zirconium oxide during the electrochemical reaction.

4. The piston manufacturing method according to claim 3, wherein the controlling the content ratio of aluminum element and zirconium element is implemented by respectively adjusting sputtering angles of the aluminum target and the zirconium target and controlling the aluminum target and the zirconium target to sputter simultaneously.

5. The piston manufacturing method according to claim 2, wherein an air pressure of the vacuum chamber before the inert gas is introduced is less than or equal to 5×10⁻⁴Pa, and the air pressure of the vacuum chamber after the inert gas is introduced is 0.1Pa-0.9Pa.

6. The piston manufacturing method according to claim 1, wherein the micro-arc oxidation method comprises:
clamping the piston base (1) with a clamp assembly;
electrically connecting a positive pole of a pulse power supply to the piston base (1), electrically connecting a negative pole of the pulse power supply to the clamp assembly, and placing the metal layer (2) on the top surface of the piston base (1) in an electrolyte, to allow the metal layer (2) to react with the electrolyte and micro-arc discharge on a surface of the metal layer (2), to form the ceramic layer (3) on the surface of the metal layer (2).

7. The piston manufacturing method according to claim 6, wherein the electrolyte is a silicate electrolyte, a concentration of the electrolyte ranges from 10g/L to 30g/L, and a temperature of the electrolyte is less than or equal to 35°C, current density of the pulse power supply ranges from 0.2A/dm² to 0.4A/dm², frequency of the pulse power supply ranges from 50Hz to 500Hz, a duty cycle of forward current of the pulse power supply ranges from 40% to 50%, and a ratio of the positive current and negative current of the pulse power supply ranges from 0.7 to 1.3.

8. The piston manufacturing method according to claim 1, wherein, before performing a magnetron spraying, the piston manufacturing method further comprises performing pretreating on the piston base (1).

9. The piston manufacturing method according to claim 8, wherein the pretreating comprises:
grinding the top surface of the piston base (1) with sandpaper to polish the top surface of the piston base (1) to be a mirror surface;
placing the piston base (1) in an ultrasonic cleaning machine, and ultrasonically cleaning the piston base (1) with a cleaning agent;
ultrasonically cleaning the piston base (1) with a deionized water, and blowing the piston base (1) dry after cleaning.

10. A piston, manufactured by the piston manufacturing method according to any one of claims 1 to 9, wherein the piston comprises:
a piston base (1);
a metal layer (2), arranged on a top surface of the piston base (1); and
a ceramic layer (3), arranged on a top surface of the metal layer (2).
